# EUROPÄISCHE PATENTANMELDUNG

(11) **EP 1 919 270 A1**
(43) Veröffentlichungstag der Anmeldung: **07.05.2008**
(21) Anmeldenummer: 08000731.3
(22) Anmeldetag: 19.05.2004
(51) Int. Cl.: H05K 7/14, H03K 17/16, F04D 25/16

(54) **Steuereinrichtung**

(30) Priorität: 23.05.2003 DE 10325371
(62) Teilanmeldung aus: 04011892.9
(71) Anmelder: AFL Europe GmbH, 72636 Frickenhausen (DE)
(72) Erfinder: Flock, Horst Mathias, 72766 Reutlingen (DE)
(74) Vertreter: Hoeger, Stellrecht & Partner Patentanwälte

(57) **Zusammenfassung**

Um bei Steuereinrichtung für an einem elektrischen Versorgungsnetz eines Kraftfahrzeugs als Last angeschlossene Aggregate, umfassend einen Steuersignalgenerator zur Erzeugung eines pulsweitenmodulierten Steuersignals, eine Leistungsendstufe mit mindestens einem Leistungsschalter zum Versorgen der jeweiligen Last, wobei der Leistungsschalter durch das an einem Steuereingang desselben anliegende Steuersignal pulsweitenmoduliert ansteuerbar ist und zur Verbindung mit dem Versorgungsnetz sowie mit der Last Anschlüsse aufweist, von denen einer durch mindestens ein Leiterstück gebildet ist, Störungen zu filtern, wird vorgeschlagen, dass eine Masseverbindung von dem Versorgungsnetz zu einem die Last aufweisenden Aggregat von einer eine Masse des Versorgungsnetzes darstellenden Fahrzeugkarosserie ausschließlich über die Leistungsendstufe der Steuereinrichtung zu der Last geführt ist.

## Beschreibung

Die Erfindung betrifft eine Steuerung für an einem elektrischen Versorgungsnetz eines Kraftfahrzeugs angeschlossene Aggregate, umfassend einen Steuersignalgenerator zur Erzeugung eines pulsweitenmodulierten Steuersignals, eine Leistungsendstufe mit mindestens einem Leistungsschalter zum Versorgen der jeweiligen Last, wobei der Leistungsschalter durch das an einem Steuereingang desselben anliegende Steuersignal pulsweitenmoduliert ansteuerbar ist und zur Verbindung mit dem Versorgungsnetz sowie mit der Last Anschlüsse aufweist, von denen einer durch mindestens ein Leiterstück gebildet ist.

Bei derartigen Steuereinrichtungen besteht das Problem Störungen zu filtern.

Diese Aufgabe wird bei einer Steuereinrichtung der eingangs beschriebenen Art erfindungsgemäß dadurch gelöst, dass eine Masseverbindung von dem Versorgungsnetz zu einem die Last aufweisenden Aggregat von einer eine Masse des Versorgungsnetzes darstellenden Fahrzeugkarosserie ausschließlich über die Leistungsendstufe der Steuereinrichtung zu der Last geführt ist.

Diese Ausbildung der erfindungsgemäßen Lösung hat den großen Vorteil, dass damit die Möglichkeit besteht, effizient Störungen im Bereich der Leistungsendstufe zu filtern und zu beseitigen, während bei einer direkten Masseverbindung zwischen dem Versorgungsnetz und dem Aggregat und einer Zweigverbindung für den Masseanschluss der Steuereinrichtung eine derartige effiziente Filterung und Entstörung nicht möglich ist.

Besonders günstig ist es, wenn die Masseverbindung über einen masseseitigen Stromanschlussträger der Steuereinrichtung geführt ist.

Eine vorteilhafte Lösung hierzu sieht vor, dass von dem Versorgungsnetz eine Masseleitung zum masseseitigen Stromanschlussträger und vom masseseitigen Stromanschlussträger eine Masseleitung zu dem die Last aufweisenden Aggregat geführt ist.

Die erfindungsgemäße Lösung ist insbesondere dann vorteilhaft einsetzbar, wenn die Last an einem Verbrennungsmotor des Kraftfahrzeugs angeordnet ist und dass der Verbrennungsmotor über eine Masseleitung zu der Steuereinrichtung mit der Fahrzeugkarosserie verbunden ist.

Bei Steuereinrichtungen gemäß dem Stand der Technik besteht insbesondere dann, wenn große Ströme fließen sollen, das Problem, den Schaltungsaufbau so auszuführen, dass einerseits möglichst geringe Leitungsinduktivitäten und andererseits auch möglichst geringe elektrische Übergangswiderstände auftreten.

Alternativ oder ergänzend wird die Aufgabe bei einer Steuerung der eingangs genannten Art erfindungsgemäß dadurch gelöst, dass in der mindestens einen Leistungsendstufe ein netzseitiger Stromanschlussträger und ein lastseitiger Stromanschlussträger vorgesehen sind und dass das mindestens eine Leiterstück jedes Leistungsschalters durch jeweils eine Klemmverbindung mit einem der Stromanschlussträger verbunden ist.

Der Vorteil dieser Lösung ist darin zu sehen, dass durch das Vorsehen der Stromanschlussträger einerseits die Möglichkeit geschaffen ist, mit geringen Widerständen große Ströme fließen zu lassen und andererseits durch das Vorsehen der Klemmverbindung für den Anschluss des Leiterstücks an einen der Stromanschlussträger eine für hohe Ströme geeignete sichere elektrische Verbindung zwischen dem Stromanschlussträger und dem Leiterstück des Leistungsschalters hergestellt werden kann.

Der Leistungsschalter kann beispielsweise zwei Paare von Leiterstücken aufweisen, die über eine Klemmverbindung mit dem jeweiligen Stromanschlussträger verbindbar sind.

Üblicherweise umfasst ein Leistungsschalter als weiteren Anschluss einen Anschlussflansch, welcher vorteilhafterweise mit dem jeweiligen anderen Stromanschlussträger verbunden ist.

Vorzugsweise ist dabei der Anschlussflansch an den jeweils anderen Stromanschlussträger angepresst anliegt.

Insbesondere wird ein derartiges angepresstes Anlegen des Anschlussflansches an dem jeweils anderen Stromanschlussträger durch ein die Presskraft ausübendes Spannelement oder Schraubelement erreicht.

Um die Leistungsschalter mit möglichst geringer Leitungsinduktivität anordnen zu können, ist vorzugsweise vorgesehen, dass die Klemmverbindung eine dem anderen Stromanschlussträger zugewandte Aufnahme für das Leiterstück aufweist.

Ferner sind - insbesondere um eine räumlich kompakte Bauweise zu erreichen - der netzseitige Stromanschlussträger und der lastseitige Stromanschlussträger parallel zueinander verlaufend angeordnet.

Dies ist besonders vorteilhaft, wenn nicht nur ein Leistungsschalter, sondern eine Vielzahl von parallelgeschalteten Leistungsschaltern vorgesehen ist, welche in einer parallel zu den Stromanschlussträgern verlaufenden Reihe angeordnet sind.

Um eine ausreichend gute Entstörung der Steuereinrichtung zu erreichen, ist bei einer bevorzugten Ausführungsform ein masseseitiger Stromanschlussträger vorgesehen, wobei zwischen dem netzseitigen Stromanschlussträger und dem masseseitigen Stromanschlussträger mindestens ein Entstörkondensator vorgesehen ist, welcher dazu dient, Spannungsspitzen, die auf das Versorgungsnetz zurückwirken, zu glätten.

Vorzugsweise ist dabei der mindestens eine Entstörkondensator so ausgebildet, dass er zwei Kondensatoranschlüsse aufweist, von denen mindestens einer als Leiterstück ausgebildet und durch mindestens eine Klemmverbindung mit einem der Stromanschlussträger verbunden ist.

Auch damit ist eine einfache und kompakte Montage des mindestens einen Entstörkondensators möglich.

Vorzugsweise ist dabei auch der andere Kondensatoranschluss als Leiterstück ausgebildet und durch jeweils eine Klemmverbindung mit dem anderen der Stromanschlussträger verbunden.

Um eine möglichst optimale Entstörwirkung mit möglichst geringen Leitungsinduktivitäten zu erreichen, ist vorzugsweise vorgesehen, dass der netzseitige Stromanschlussträger und der masseseitige Stromanschlussträger im Abstand nebeneinanderliegend angeordnet sind, so dass die Möglichkeit besteht, die Entstörkondensatoren mit möglichst kurzen Leitungen mit den beiden Stromanschlussträgern zu verbinden.

Besonders günstig ist es dabei, wenn die Klemmverbindungen an den Stromanschlussträgern in einem Abstand angeordnet sind, welcher ungefähr einem Abstand der aus dem mindestens einen Entstörkondensator austretenden Leiterstücke entspricht. Damit besteht die Möglichkeit, die Leiterstücke des Entstörkondensators ohne große Leitungsinduktivitäten mit den Stromanschlussträgern zu verbinden.

Vorzugsweise sind der netzseitige Stromanschlussträger und der masseseitige Stromanschlussträger durch einen Isolierkörper gegeneinander elektrisch isoliert und insbesondere durch den Isolierkörper im Abstand gehalten.

Besonders vorteilhaft ist die erfindungsgemäße Konzeption hinsichtlich der vorgesehenen Entstörkondensatoren dann, wenn mehrere Entstörkondensatoren vorgesehen sind, da diese mehreren Entstörkondensatoren dann in einer zu den Stromanschlussträgern parallel verlaufenden Reihe angeordnet sind.

Darüber hinaus ist insbesondere dann, wenn die Lasten induktive Lasten sind, in der Steuereinrichtung ein masseseitiger Stromanschlussträger vorgesehen, wobei zwischen dem lastseitigen Stromanschlussträger und dem masseseitigen Stromanschlussträger mindestens eine Freilaufdiode vorgesehen ist, welche in der Lage ist, einen Freilaufstrom zwischen dem lastseitigen Stromanschlussträger und dem masseseitigen Stromanschlussträger fließen zu lassen.

Besonders günstig ist es dabei wenn die mindestens eine Freilaufdiode zwei Diodenanschlüsse aufweist und wenn mindestens einer der Diodenanschlüsse als Leiterstück ausgebildet und durch jeweils eine Klemmverbindung mit einem der Stromanschlussträger verbunden ist.

Vorzugsweise ist dabei der andere Diodenanschluss als Anschlussflansch ausgebildet und über diesen mit dem jeweils anderen Stromanschlussträger verbunden.

Zweckmäßigerweise ist dabei der Anschlussflansch mit dem Stromanschlussträger derart verbunden, dass der Anschlussflansch an dem jeweiligen Stromanschlussträger angepresst anliegt.

Besonders vorteilhaft ist es, insbesondere um die mindestens eine Diode mit möglichst geringen Leitungsinduktivitäten anschließen zu können, wenn die Klemmverbindung eine dem anderen Stromanschlussträger zugewandte Aufnahme aufweist.

Besonders günstig ist es für eine kompakte Bauweise, wenn der lastseitige Stromanschlussträger und der masseseitige Stromanschlussträger parallel zueinander verlaufen.

Insbesondere dann, wenn große Ströme von den Freilaufdioden aufgenommen werden sollen, ist vorzugsweise eine Vielzahl von Freilaufdioden vorgesehen, welche in einer parallel zu den Stromanschlussträgern verlaufenden Reihe angeordnet sind.

Hinsichtlich der Ausbildung der Klemmverbindungen wurden im Zusammenhang mit den bisher beschriebenen Ausführungsbeispielen keine näheren Angaben gemacht.

So ist es besonders günstig, wenn die Klemmverbindung durch zwei Klemmbacken eines Klemmkörpers gebildet ist, so dass sich die Klemmverbindung sehr einfach durch den Klemmkörper mit seinen Klemmbacken realisieren lässt.

Diese Lösung ist konstruktiv besonders einfach dann realisierbar, wenn die Klemmbacken einstückig an dem Klemmkörper angeformt sind. Der Vorteil dieser Lösung ist insbesondere auch hinsichtlich der elektrischen Verbindung zu sehen, da beide Klemmbacken aufgrund ihrer einstückigen Verbindung mit dem Klemmkörper einen Strom ohne Übergangswiderstand zwischen Klemmbacken und Klemmkörper aufnehmen können.

Um derartige Klemmkörper besonders einfach und günstig herstellen zu können, ist vorzugsweise vorgesehen, dass der Klemmkörper durch einen Abschnitt einer Profilschiene gebildet ist, welche mindestens eine Nut aufweist und mit beiderseits der Nut angeordneten Nutwänden die Klemmbacken bildet.

Vorzugsweise ist insbesondere bei einer Vielzahl von Leistungsschaltern oder Entstörkondensatoren oder Freilaufdioden vorgesehen, dass jeder Stromanschlussträger mit einer Vielzahl von Klemmkörpern versehen ist.

Eine hinsichtlich der Ausführung besonders zweckmäßige Lösung sieht dabei vor, dass der Stromanschlussträger selbst als die Klemmkörper bildende Profilschiene ausgebildet ist.

Im Fall einer Vielzahl von Klemmkörpern als Teil der Profilschiene lassen sich diese Klemmkörper besonders einfach durch auf mindestens einer Seite der Nut angeordnete getrennte Nutwandabschnitte realisieren.

Diese Nutwandabschnitte können im Fall einer Profilschiene besonders einfach dadurch in der jeweiligen Nutwand quer zur Längsrichtung der Nut verlaufende Einschnitte gebildet werden.

Weitere Merkmale und Vorteil der Erfindung sind Gegenstand der nachfolgenden Beschreibung sowie der zeichnerischen Darstellung einiger Ausführungsbeispiele.

In der Zeichnung zeigen:

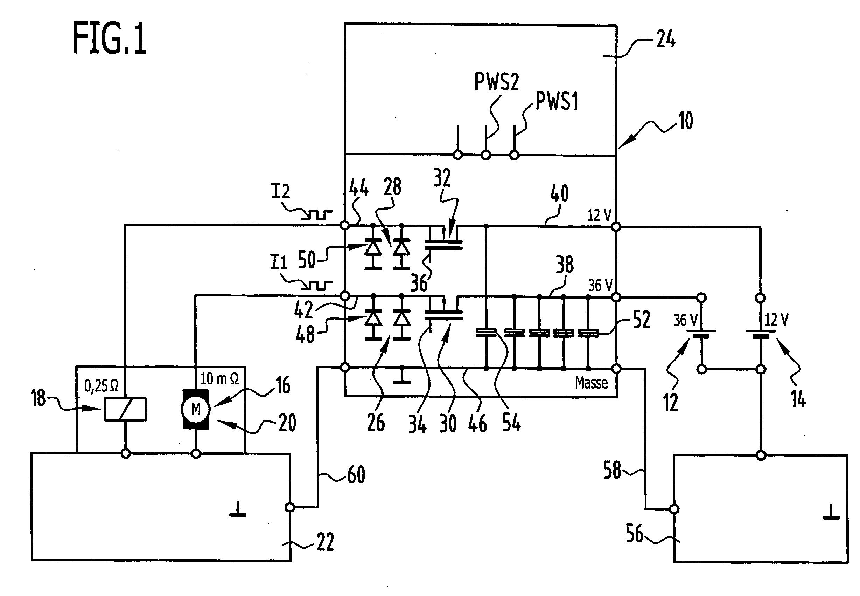

- Fig. 1: eine schematische Darstellung einer erfindungsgemäßen Steuereinrichtung, angeordnet zwischen fahrzeugseitigen Versorgungsnetzen und einem Aggregat eines Fahrzeugs;
- Fig. 2: eine schematische Darstellung einer vorteilhaften Ausführungsform einer erfindungsgemäßen Leistungsendstufe für eine Last;
- Fig. 3: eine räumliche ausschnittsweise Darstellung eines Schaltungsaufbaus der Schaltung gemäß Fig. 2;
- Fig. 4: eine Draufsicht in Richtung des Pfeils A in Fig. 3;
- Fig. 5: eine Darstellung eines lastseitigen Stromanschlussträgers mit Blick in Richtung des Pfeils A in Fig. 3;
- Fig. 6: eine Draufsicht auf den lastseitigen Stromanschlussträger in Richtung des Pfeils B in Fig. 5;
- Fig. 7: eine Ansicht des lastseitigen Stromanschlussträgers in Richtung des Pfeils C in Fig. 5;
- Fig. 8: eine Ansicht ähnlich Fig. 5 eines netzseitigen Stromanschlussträgers;
- Fig. 9: eine Ansicht ähnlich Fig. 6 des netzseitigen Stromanschlussträgers;
- Fig. 10: eine Ansicht ähnlich Fig. 7 des netzseitigen Stromanschlussträgers;
- Fig. 11: eine Ansicht ähnlich Fig. 5 eines masseseitigen Stromanschlussträgers;
- Fig. 12: eine Ansicht ähnlich Fig. 6 des masseseitigen Stromanschlussträgers und
- Fig. 13: eine Ansicht ähnlich Fig. 7 des masseseitigen Stromanschlussträgers.

Ein Ausführungsbeispiel einer als Ganzes mit 10 bezeichneten erfindungsgemäßen Steuereinrichtung ist beispielsweise mit einem ersten elektrischen Versorgungsnetz 12 und einem zweiten elektrischen Versorgungsnetz 14 eines zeichnerisch nicht dargestellten Kraftfahrzeugs verbunden und dient dazu, eine erste Last 16 und eine zweite Last 18 anzusteuern, wobei beispielsweise die erste Last 16 ein Anlassermotor eines Anlassers 20 für einen Verbrennungsmotor 22 des Kraftfahrzeugs ist und die zweite Last 18 ein Einrückmagnet des Anlassers 20.

Zum Betreiben der ersten Last 16 und der zweiten Last 18 ist die Steuereinrichtung 10 mit einem als Ganzes mit 24 bezeichneten Steuersignalgenerator versehen, welcher in der Lage ist, durch pulsweitenmodulierte Steuersignale PWS1 und PW2 sowohl eine erste Endstufe 26 zum Betreiben der ersten Last 16 am ersten Versorgungsnetz 12 als auch eine zweite Endstufe 28 zum Betreiben der zweiten Last 18 am zweiten Versorgungsnetz 14 anzusteuern, von denen jede einen durch Pulsweitenmodulation steuerbaren Strom I1 bzw. I2 zur Versorgung der ersten Last 16 bzw. der zweiten Last 18 liefert.

Zur Erzeugung des durch Pulsweitenmodulation gesteuerten Stroms I1 bzw. I2 umfasst jede der Leistungsendstufen 26 bzw. 28 eine Vielzahl von parallelgeschalteten Leistungsschaltern 30 bzw. 32, die einen Steuereingang 34 bzw. 36 aufweisen, welcher durch den Steuersignalgenerator 24 mit den Steuersignalen PWS1 und PWS2 ansteuerbar ist, um mit diesen Leistungsschaltern 30 bzw. 32 einen von einem netzseitigen Stromanschlussträger 38 bzw. 40 zu einem lastseitigen Stromanschlussträger 42 bzw. 44 fließenden Strom durch Ein- und Ausschalten entsprechend den Steuersignalen PWS1 und PWS2 an den Steuereingängen 34 bzw. 36 steuern.

Darüber hinaus sind zwischen dem lastseitigen Stromanschlussträger 42 bzw. 44 und Masse an einem masseseitigen Stromanschlussträger 46 der Leistungsendstufen 26, 28 parallelgeschaltete Freilaufdioden 48 bzw. 50 vorgesehen, die einen beim Ausschalten der Leistungsschalter 30 bzw. 32 aufgrund einer Induktivität der jeweiligen Last 16 bzw. 18 auftretenden Freilaufstrom übernehmen.

Ferner sind in jeder der Leistungsendstufen 26 bzw. 28 parallelgeschaltete Entstörkondensatoren 52 bzw. 54 zwischen dem netzseitigen Stromanschlussträger 38 bzw. 40 und dem masseseitigen Stromanschlussträger 46 angeordnet.

Erfindungsgemäß ist der Verbrennungsmotor 22 nicht direkt mit einer Fahrzeugkarosserie 56 des Kraftfahrzeugs verbunden, um eine Masseverbindung zwischen dem ersten Netz 12 und dem zweiten Netz 14 herzustellen, sondern von der Fahrzeugkarosserie 56 ist eine Masseleitung 58 zu dem masseseitigen Stromanschlussträger 46 in der erfindungsgemäßen Steuereinrichtung 10 geführt und von dem masseseitigen Stromanschlussträger 46 eine Masseleitung 60 zu dem Verbrennungsmotor 22, so dass die Entstörkondensatoren 52 und 54 mit möglichst kurzen und somit eine geringe Induktivität aufweisenden Leitungsstrecken und ohne Streuinduktivität mit der jeweiligen Last 16 bzw. 18 verbunden sind, um eine möglichst optimale Wirkung der Entstörkondensatoren 52 bzw. 54 zu erreichen.

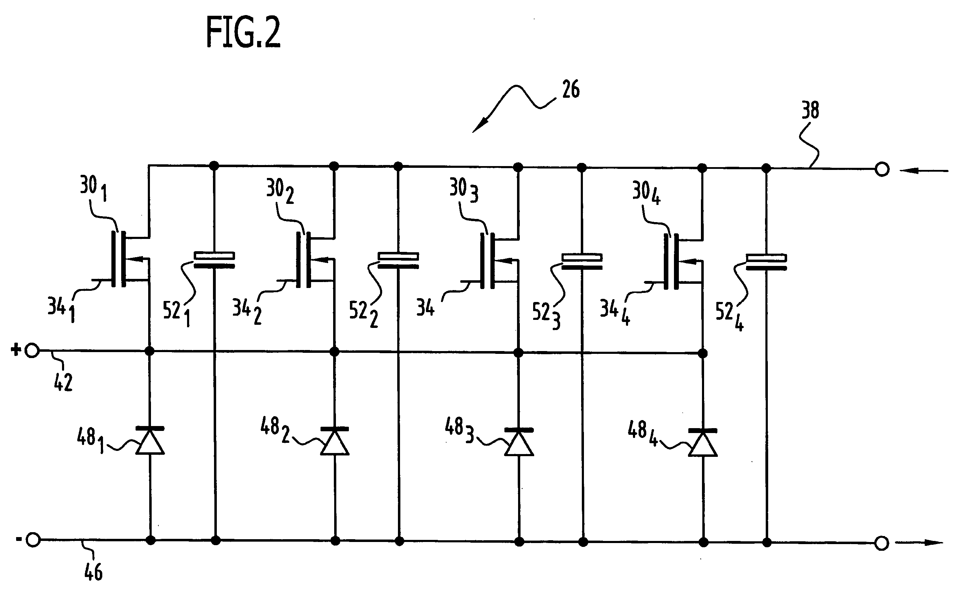

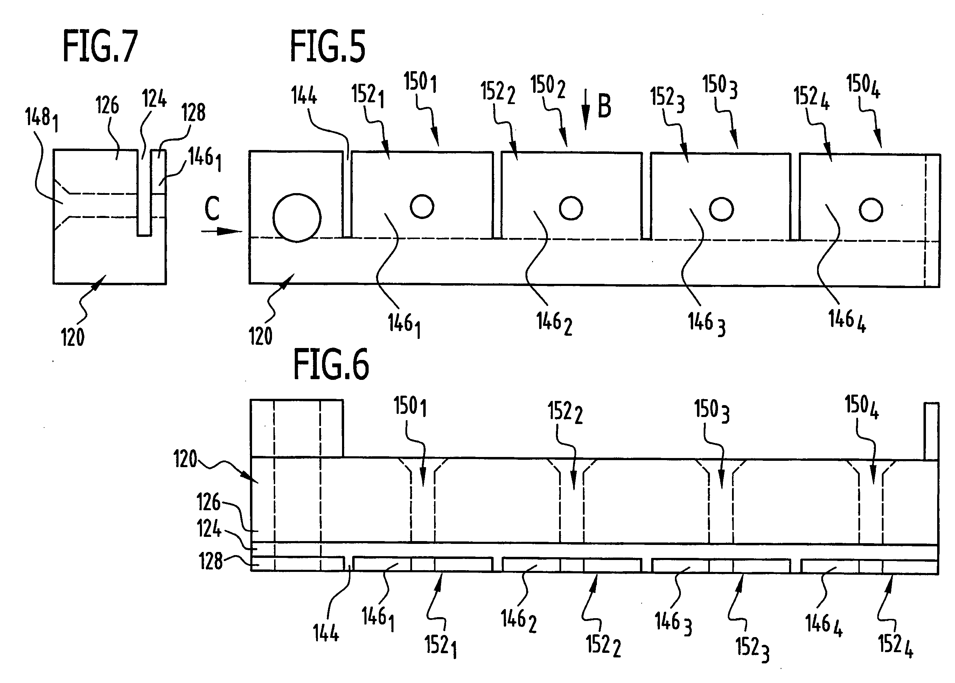

Der elektrische Aufbau einer derartigen Leistungsendstufe 26 bzw. 28 ist exemplarisch am Beispiel der Leistungsendstufe 26 in Fig. 2 bis Fig. 13 anhand eines Schaltbildes nochmals dargestellt, wobei die Leistungsendstufe 26 beispielsweise vier Leistungsschalter 30₁ bis 30₄, beispielsweise Halbleiterschalter, insbesondere Feldeffekttransistoren oder ähnliche Halbleiter, umfasst, die über ihre Steuereingänge 34₁bis 34₄ steuerbar sind.

Ferner sind beispielsweise jedem der Leistungsschalter 30₁bis 30₄ jeweils ein Entstörkondensator 52₁bis 52₄ zugeordnet, die - wie bereits dargelegt - mit dem netzseitigen Stromanschlussträger 38 und dem masseseitigen Stromanschlussträger 46 elektrisch verbunden sind.

Darüber hinaus ist beispielsweise auch jedem der Leistungsschalter 30₁ bis 30₄ eine eigene Freilaufdiode 48₁ bis 48₄ zugeordnet, welche jeweils zwischen dem lastseitigen Stromanschlussträger 42 und dem masseseitigen Stromanschlussträger 46 liegen.

Es ist aber auch denkbar, die Zahl der Entstörkondensatoren 42 und/oder die Zahl der Freilaufdioden 48 unabhängig von der Zahl der Leistungsschalter 30 zu wählen.

Da eine derartige Leistungsendstufe 26 mit großen Strömen und relativ hohen Schaltfrequenzen arbeitet, ist nicht nur die Verschaltung der einzelnen Bauteile 30, 48, 52 maßgebend, sondern auch deren körperliche und möglichst geringinduktive Anordnung relativ zueinander.

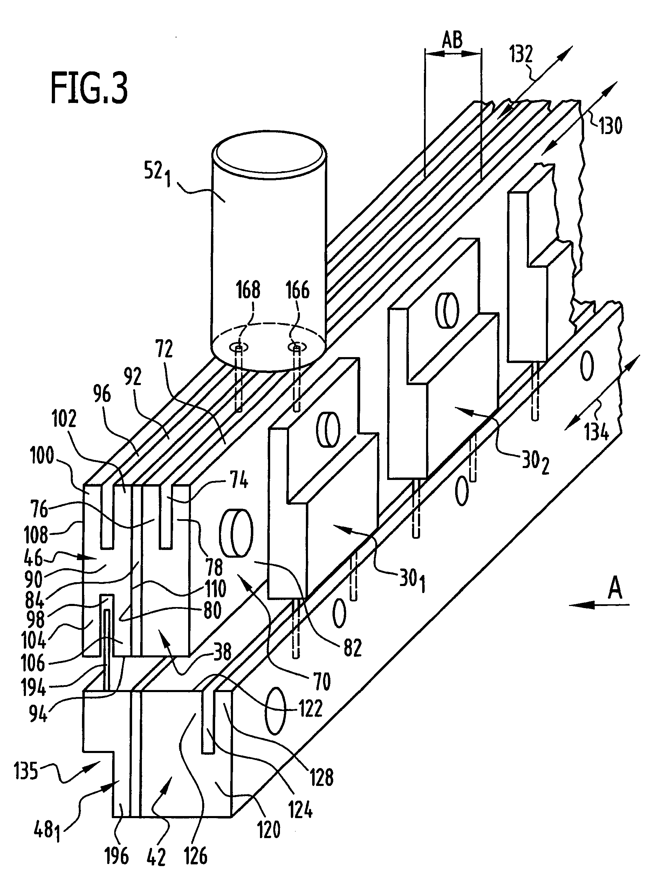

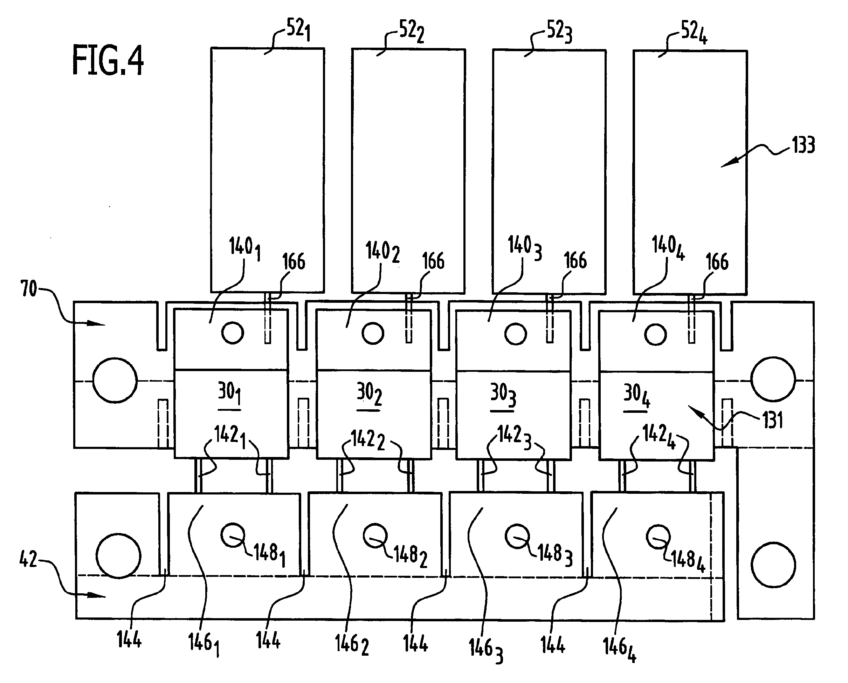

Wie in Fig. 3 und 4 dargestellt, ist der netzseitige Stromanschlussträger 38 als Profilschiene 70 ausgebildet, welche an einer Schmalseite 72 mit einer von dieser ausgehend in die Profilschiene 70 eintauchenden Nut 74 versehen ist, die beiderseits durch Nutwände 76, 78 begrenzt ist.

Ferner weist die Profilschiene 70 einander gegenüberliegende Breitseiten 80, 82 auf, wobei an der Breitseite 80 über einen Isolierkörper 84 abgestützt der masseseitige Stromanschlussträger 46 gehalten ist, welcher ebenfalls als Profilschiene 90 ausgebildet ist, von deren einander gegenüberliegenden Schmalseiten 92 und 94 ausgehend jeweils eine Nut 96 bzw. 98 eintaucht, die ihrerseits durch Nutwände 100, 102 bzw. 104, 106 begrenzt sind.

Die Profilschiene 90 ist dabei vorzugsweise so angeordnet, dass deren Breitseiten 108 bzw. 110 parallel zu den Breitseiten 80 und 82 verlaufen und beispielsweise die Breitseite 110 an dem Isolierkörper 84 anliegt.

Darüber hinaus ist auch der lastseitige Stromanschlussträger 42 als Profilschiene 120 ausgebildet, die ebenfalls eine von einer Schmalseite 122 ausgehend in diesen eindringende Nut 124 aufweist, welche durch Nutwände 126 und 128 begrenzt ist.

Vorzugsweise sind der netzseitige Stromanschlussträger 38, der masseseitige Stromanschlussträger 46 und der lastseitige Stromanschlussträger 42 derart angeordnet, dass deren Längsrichtungen 130, 132 und 134 im Wesentlichen parallel zueinander verlaufen.

Die Leistungsschalter 30₁ bis 30₄ sind, wie in Fig. 4 dargestellt, so ausgebildet, dass diese Anschlussflansche 140₁ bis 140₄ aufweisen und mit diesen Anschlussflanschen 140₁ bis 140₄ an der Breitseite 82 der Profilschiene 70 anliegen. Damit liegen alle parallelgeschalteten Leistungsschalter 30₁ bis 30₄ in einer parallel zu den Längsrichtungen 130 und 134 der Stromanschlussträger 38, 42 verlaufenden Reihe 131.

Ferner weisen die Leistungsschalter 30₁ bis 30₄ jeweils mit dem lastseitigen Stromanschlussträger 42 zu verbindende Paare von Leiterstücken 142₁ bis 142₄ auf, wobei die Leiterstücke 142₁ bis 142₄ in die dem netzseitigen Stromanschlussträger 38 zugewandte Nut 124 der von dem lastseitigen Stromanschlussträger 42 umfassten Profilschiene 120 eintauchen.

Um die einzelnen Paare von Leiterstücken 142₁ bis 142₄ in der Nut 124 zu fixieren, ist mindestens die Nutwand 128 durch sich von der Schmalseite 122 ausgehende Einschnitte 144 in Klemmbacken bildende Nutwandabschnitte 146₁ bis 146₄ unterteilt, so dass die einzelnen Nutwandabschnitte 146₁ bis 146₄ unabhängig voneinander in Richtung der Nutwand 126 biegbar sind, um das zwischen dem jeweiligen Nutwandabschnitt 146 und der Nutwand 126 liegenden Paar von Leiterstücken 142 zwischen der Nutwand 126 und dem jeweiligen Nutwandabschnitt 146 einzuklemmen.

Beispielsweise wird mit dem Nutwandabschnitt 146₁ das Paar von Leiterstücken 142₁ zwischen diesem und der Nutwand 126 eingeklemmt.

Zum Deformieren der Nutwandabschnitte 146₁ bis 146₄ und Einklemmen der Paare von Leiterstücken 142 ist jeder der Nutwandabschnitte 146 durch eine Spannschraube 148 beaufschlagbar, welche den Nutwandabschnitt 146 und die Nutwand 126 durchsetzt und beispielsweise beim Einschrauben in die Nutwandabschnitte 146 diese in Richtung der Nutwand 126 beaufschlagt.

Damit bildet jeder der Nutwandabschnitte 146₁ zusammen mit der Nutwand 126 eine Klemmverbindung 150₁ bis 150₄ deren Klemmbacken die Nutwände 126 und der jeweilige Nutwandabschnitt 146 darstellen und die Nut 124 die Aufnahme für die Leiterstücke 142 bildet.

Insgesamt stellt somit die Profilschiene 120 eine Aneinanderreihung von Klemmkörpern 152₁ bis 152₄ dar.

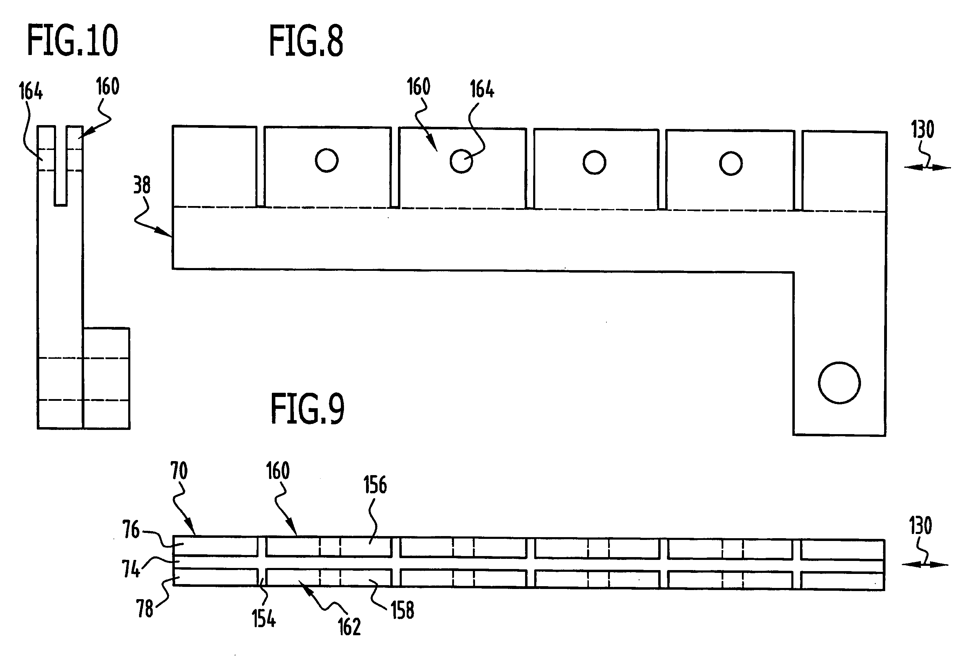

Wie in Fig. 8 bis 10 dargestellt, sind auch die Nutwände 76 und 78 der Profilschiene 70 durch die gesamte Profilschiene 70 quer zu ihrer Längsrichtung 130 durchsetzende Einschnitte 154 in Nutwandabschnitte 156 und 158 aufgeteilt, die jeweils eine Klemmverbindung 160 bilden, deren Klemmkörper 162 durch den jeweiligen Abschnitt der Profilschiene 70 gebildet ist, wobei eine Spannschraube 164 vorgesehen ist, um die Nutwandabschnitte 156 und 158 miteinander zu verspannen.

Jede dieser Klemmverbindungen 160 dient dazu, ein in Fig. 4 dargestelltes Leiterstück 166 von einem der Entstörkondensatoren 52₁ bis 52₄ einzuspannen und damit zu kontaktieren.

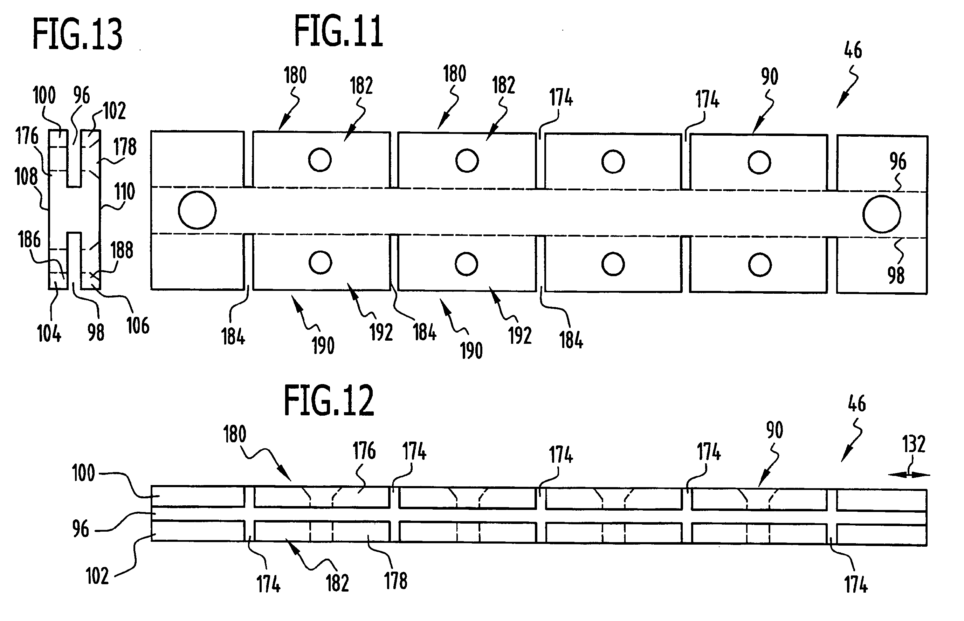

Ein anderes Leiterstück 168 der Entstörkondensatoren 52₁bis 52₄ ist, wie in Fig. 11 bis 13 dargestellt, in der Nut 96 der Profilschiene 90 einspannbar, wobei ebenfalls die Nutwände 100 und 102 durch Einschnitte 174 in Klemmbacken bildende Nutwandabschnitte 176, 178 unterteilt sind, welche eine Klemmverbindung 180 mit einem Klemmkörper 182 bilden, der durch eine Klemmschraube durch Zusammenziehen der Nutwandabschnitte 176 und 178 in der Lage ist, das Leiterstück 168 des jeweiligen Entstörkondensators 52₁ bis 52₄ einzuspannen.

Um die Entstörkondensatoren 52₁ bis 52₄ in einer parallel zu den Längsrichtungen 130 und 132 verlaufenden Reihe 133 anordnen zu können, liegen die Klemmkörper 162 und 182 ebenfalls in in den Längsrichtungen 130 und 132 verlaufenden Reihen in einem Abstand AB, welcher den Abstand der aus den Entstörkondensatoren 52₁ bis 52₄ austretenden Leiterstücke 166 und 168 entspricht, und die Aufnahme für die Leiterstücke 166 und 168 bildenden Nuten 74 und 96 sind der Reihe 133 der Entstörkondensatoren 52₁ bis 52₄ zugewandt.

Darüber hinaus sind auch die Nutwände 104 und 106 der Profilschiene 90 durch Einschnitte 184 in Klemmbacken bildende Nutwandabschnitte 186 und 188 unterteilt, welche somit in der Lage sind, Klemmverbindungen 190 mit Klemmkörpern 192 zu bilden, wobei mit diesen Klemmverbindungen 190, wie in Fig. 3 dargestellt, Leiterstücke 194 der Freilaufdioden 48 einspannbar sind, die damit mit dem masseseitigen Stromanschlussträger 46 verbindbar sind und andererseits mit einem Anschlussflansch 196 an der Profilschiene 120 anliegen und mit dieser verbunden sind.

Vorzugsweise sind dabei die Anschlussflansche 196 ebenfalls mit der Profilschiene 120 verschraubt.

Somit liegen auch die Freilaufdioden 48₁ bis 48₄ in einer parallel zu den Längsrichtungen 132 und 134 verlaufenden Reihe 135.

Durch die erfindungsgemäße parallele Anordnung der Profilschienen 70, 90 und 120 und der in zu diesen parallelen Reihen 131, 133 und 135 angeordneten parallelgeschalteten Bauteile 30, 48, 52 ist eine kompakte und somit geringe Leitungslängen zwischen den einzelnen Bauteilen 30, 48, 52 erfordernde Bauweise der Leistungsendstufe 26 mit optimaler Entstörwirkung der Entstörkondensatoren 52 realisierbar.

## Patentansprüche

1. Steuereinrichtung für an einem elektrischen Versorgungsnetz (12, 14) eines Kraftfahrzeugs als Last (16, 18) angeschlossene Aggregate (20), umfassend einen Steuersignalgenerator (24) zur Erzeugung eines pulsweitenmodulierten Steuersignals (PWS1, PWS2), eine Leistungsendstufe (26, 28) mit mindestens einem Leistungsschalter (30, 32) zum Versorgen der jeweiligen Last (16, 18), wobei der Leistungsschalter (30, 32) durch das an einem Steuereingang (34, 36) desselben anliegende Steuersignal (PWS1, PWS2) pulsweitenmoduliert ansteuerbar ist und zur Verbindung mit dem Versorgungsnetz (12, 14) sowie mit der Last (16, 18) Anschlüsse (140, 142) aufweist, von denen einer durch mindestens ein Leiterstück (142) gebildet ist,
**dadurch gekennzeichnet, dass** eine Masseverbindung von dem Versorgungsnetz (12, 14) zu einem die Last (16, 18) aufweisenden Aggregat (20) von einer eine Masse des Versorgungsnetzes (12, 14) darstellenden Fahrzeugkarosserie (56) ausschließlich über die Leistungsendstufe (26, 28) der Steuereinrichtung (10) zu der Last (16, 18) geführt ist.

2. Steuereinrichtung nach Anspruch 1, **dadurch gekennzeichnet, dass** die Masseverbindung über einen masseseitigen Stromanschlussträger (46) der Steuereinrichtung (10) geführt ist.

3. Steuereinrichtung nach Anspruch 2, **dadurch gekennzeichnet, dass** von dem Versorgungsnetz (12, 14) eine Masseleitung (58) zum masseseitigen Stromanschlussträger (46) und vom masseseitigen Stromanschlussträger (46) eine Masseleitung (60) zu dem die Last (16, 18) aufweisenden Aggregat (20) geführt ist.

4. Steuereinrichtung nach einem der voranstehenden Ansprüche, **dadurch gekennzeichnet, dass** die Last (16, 18) an einem Verbrennungsmotor (22) des Kraftfahrzeugs angeordnet ist und dass der Verbrennungsmotor (22) über eine Masseleitung (60) zu der Steuereinrichtung (10) mit der Fahrzeugkarosserie (56) verbunden ist.

5. Steuereinrichtung nach dem Oberbegriff des Anspruchs 1 oder nach einem der voranstehenden Ansprüche, **dadurch gekennzeichnet, dass** in der mindestens einen Leistungsendstufe (26, 28) ein netzseitiger Stromanschlussträger (38, 40) und lastseitiger Stromanschlussträger (42, 44) vorgesehen sind und dass das mindestens eine Leiterstück (142) jedes Leistungsschalters (30, 32) durch jeweils eine Klemmverbindung (150) mit einem der Stromanschlussträger (42) verbunden ist.

6. Steuereinrichtung nach Anspruch 5, **dadurch gekennzeichnet, dass** jeder der Leistungsschalter (30, 32) als weiteren Anschluss einen Anschlussflansch (140) aufweist und dass der Anschlussflansch (140) mit dem jeweils anderen Stromanschlussträger (38) verbunden ist.

7. Steuereinrichtung nach Anspruch 6, **dadurch gekennzeichnet, dass** der Anschlussflansch (140) an den jeweiligen Stromanschlussträger (38) angepresst anliegt.

8. Steuereinrichtung nach einem der voranstehenden Ansprüche, **dadurch gekennzeichnet, dass** die Klemmverbindung (150) eine dem anderen Stromanschlussträger (38) zugewandte Aufnahme (124) für das Leiterstück (142) aufweist.

9. Steuereinrichtung nach einem der voranstehenden Ansprüche, **dadurch gekennzeichnet, dass** der netzseitige Stromanschlussträger (38, 40) und der lastseitige Stromanschlussträger (42, 44) parallel zueinander verlaufen.

10. Steuereinrichtung nach Anspruch 9, **dadurch gekennzeichnet, dass** eine Vielzahl von parallelgeschalteten Leistungsschaltern (30, 32) vorgesehen ist, welche in einer parallel zu den Stromanschlussträgern (38, 40, 42, 44) verlaufenden Reihe (131) angeordnet sind.

11. Steuereinrichtung nach einem der voranstehenden Ansprüche, **dadurch gekennzeichnet, dass** ein masseseitiger Stromanschlussträger (46) vorgesehen ist und dass zwischen dem netzseitigen Stromanschlussträger (38) und dem masseseitigen Stromanschlussträger (46) mindestens ein Entstörkondensator (52, 54) vorgesehen ist.

12. Steuereinrichtung nach Anspruch 11, **dadurch gekennzeichnet, dass** der mindestens eine Entstörkondensator (52) zwei Kondensatoranschlüsse (166, 168) aufweist, von denen mindestens einer als Leiterstück (166) ausgebildet und durch mindestens eine Klemmverbindung (160) mit einem (38) der Stromanschlussträger (38, 46) verbunden ist.

13. Steuereinrichtung nach Anspruch 12, **dadurch gekennzeichnet, dass** der andere Kondensatoranschluss als Leiterstück (168) ausgebildet ist und durch jeweils eine Klemmverbindung (180) mit dem anderen (46) der Stromanschlussträger (38, 46) verbunden ist.

14. Steuereinrichtung nach einem der Ansprüche 11 bis 13, **dadurch gekennzeichnet, dass** der netzseitige Stromanschlussträger (38) und der masseseitige Stromanschlussträger (46) mit Abstand nebeneinanderliegend angeordnet sind.

15. Steuereinrichtung nach Anspruch 14, **dadurch gekennzeichnet, dass** die Klemmverbindungen (160, 180) mit ihren Aufnahmen (76, 96) für die Leiterstücke an den Stromanschlussträgern (38, 46) in einem Abstand (AB) angeordnet sind, welcher ungefähr einem Abstand der aus dem mindestens einen Entstörkondensator (52, 54) austretenden Leiterstücke (166, 168) entspricht.

16. Steuereinrichtung nach Anspruch 14 oder 15, **dadurch gekennzeichnet, dass** der netzseitige Stromanschlussträger (38) und der masseseitige Stromanschlussträger (46) durch einen Isolierkörper (84) gegeneinander elektrisch isoliert sind.

17. Steuereinrichtung nach einem der Ansprüche 8 bis 13, **dadurch gekennzeichnet, dass** mehrere Entstörkondensatoren (52, 54) in einer zu den Stromanschlussträgern (38, 46) parallel verlaufenden Reihe (133) angeordnet sind.

18. Steuereinrichtung nach einem der voranstehenden Ansprüche, **dadurch gekennzeichnet, dass** ein masseseitiger Stromanschlussträger (46) vorgesehen ist, und dass zwischen dem lastseitigen Stromanschlussträger (42, 44) und dem masseseitigen Stromanschlussträger (46) mindestens eine Freilaufdiode (48, 50) vorgesehen ist.

19. Steuereinrichtung nach Anspruch 18, **dadurch gekennzeichnet, dass** die mindestens eine Freilaufdiode (48) zwei Diodenanschlüsse (194, 196) aufweist und dass mindestens einer der Diodenanschlüsse (194, 196) als Leiterstück (194) ausgebildet und durch jeweils eine Klemmverbindung (190) mit einem (46) der Stromanschlussträger (42, 46) verbunden ist.

20. Steuereinrichtung nach Anspruch 19, **dadurch gekennzeichnet, dass** der andere Diodenanschluss als Anschlussflansch (196) ausgebildet und über diesen mit dem jeweils anderen Stromanschlussträger (42) verbunden ist.

21. Steuereinrichtung nach Anspruch 20, **dadurch gekennzeichnet, dass** der Anschlussflansch (196) an dem jeweiligen Stromanschlussträger (42) angepresst anliegt.

22. Steuereinrichtung nach einem der Ansprüche 19 bis 21, **dadurch gekennzeichnet, dass** die Klemmverbindung (190) eine dem anderen Stromanschlussträger (38) zugewandte Aufnahme (98) aufweist.

23. Steuereinrichtung nach einem der Ansprüche 19 bis 22, **dadurch gekennzeichnet, dass** der lastseitige Stromanschlussträger (42, 44) und der masseseitige Stromanschlussträger (46) parallel zueinander verlaufen.

24. Steuereinrichtung nach Anspruch 23, **dadurch gekennzeichnet, dass** eine Vielzahl von parallelgeschalteten Freilaufdioden (48, 50) vorgesehen ist, welche in einer parallel zu den Stromanschlussträgern (42, 44, 46) verlaufenden Reihe (133) angeordnet sind.

25. Steuereinrichtung nach einem der voranstehenden Ansprüche, **dadurch gekennzeichnet, dass** die Klemmverbindung (150, 160, 180, 190) durch Klemmbacken (126, 146; 156, 158; 176, 178; 186, 188) eines Klemmkörpers (152, 162, 182, 192) gebildet ist.

26. Steuereinrichtung nach Anspruch 25, **dadurch gekennzeichnet, dass** die Klemmbacken (126, 146; 156, 158; 176, 178; 186, 188) einstückig an den Klemmkörper (152, 162, 182, 192) angeformt sind.

27. Steuereinrichtung nach Anspruch 26, **dadurch gekennzeichnet, dass** der Klemmkörper (152, 162, 182, 192) durch einen Abschnitt einer Profilschiene (70, 90, 120) gebildet ist, welche mindestens eine Nut (74, 96, 98, 124) aufweist und mit beiderseits der Nut (74, 96, 98, 124) angeordneten Nutwänden Klemmbacken (126, 146; 156, 158; 176, 178; 186, 188) bildet.

28. Steuereinrichtung nach einem der Ansprüche 25 bis 27, **dadurch gekennzeichnet, dass** jeder Stromanschlussträger (38, 42, 46) mit einer Vielzahl von Klemmkörpern (152, 162, 182, 192) versehen ist.

29. Steuereinrichtung nach einem der Ansprüche 25 bis 28, **dadurch gekennzeichnet, dass** der Stromanschlussträger (38, 42, 46) selbst als die Klemmkörper (152, 162, 182, 192) bildende Profilschiene (70, 90, 120) ausgebildet ist.

30. Steuereinrichtung nach Anspruch 28 oder 29, **dadurch gekennzeichnet, dass** die Vielzahl von Klemmkörpern (152, 162, 182, 192) durch auf mindestens einer Seite der Nut (74, 96, 98, 124) angeordnete getrennte Nutwandabschnitte (146, 156, 158, 176, 178, 186, 188) gebildet ist.

31. Steuereinrichtung nach Anspruch 30, **dadurch gekennzeichnet, dass** die Nutwandabschnitte (146, 156, 158, 176, 178, 186, 188) durch in der jeweiligen Nutwand (76, 78, 100, 102, 104, 106, 126, 128) quer zur Längsrichtung (130, 132, 134) der Nut (74, 96, 98, 124) verlaufende Einschnitte (144, 154, 174, 184) gebildet sind.
